# EUROPÄISCHE PATENTSCHRIFT

(11) **EP 0 580 944 B1**
(45) Veröffentlichungstag und Bekanntmachung des Hinweises auf die Patenterteilung: **22.05.1996**
(21) Anmeldenummer: 93103917.6
(22) Anmeldetag: 11.03.1993
(51) Int. Cl.: C23C 18/12, C23C 16/40

(54) **Verfahren und Vorrichtung zur Herstellung eines Metall-Kunststoff-Verbundes**
Method and device for manufacture of a metal plastic composite
Procédé et dispositif pour la fabrication d'un composite métal-plastique

(30) Priorität: 30.07.1992 DE 4225106
(43) Veröffentlichungstag der Anmeldung: 02.02.1994
(73) Patentinhaber: HERAEUS KULZER GMBH, 63450 Hanau (DE)
(72) Erfinder: Tiller, Hans-Jürgen, Prof. Dr., O-6900 Jena (DE); Magnus, Brigitte, O-6900 Jena-Winzerla (DE); Schödel, Dieter, Dr., W-6200 Wiesbaden (DE); Oppawsky, Steffen, W-6380 Bad Homburg (DE)

(56) Entgegenhaltungen:
- EP-A- 0 151 233
- EP-A- 0 299 754
- EP-A- 0 327 311
- EP-A- 0 387 403
- US-A- 4 099 990
- US-A- 4 900 591
- US-A- 4 981 724

## Beschreibung

Die vorliegende Erfindung betrifft ein Verfahren zur Herstellung eines Metall-Kunststoff-Verbundes, insbesondere für die Dentalprothetik, wobei auf einem metallischen Teil eine haftvermittelnde Oxidschicht aufgebaut wird, die dann mit einem (Dental-) Kunststoff verbunden wird, wobei zwischen dem metallischen Teil und einer ihr benachbarten Elektrode eine elektrische Spannung aufrechterhalten wird und wobei eine siliziumorganische Verbindung in den Raum zwischen der Elektrode und dem Teil zur Bildung der Oxidschicht eingeleitet wird.

Weiterhin betrifft die Erfindung eine Vorrichtung zur Herstellung eines Metall-Kunststoff-Verbundes, insbesondere für die Dentalprothetik, wobei auf einem metallischen Teil eine haftvermittelnde Oxidschicht aufgebaut wird, die dann mit einem Dentalkunststoff verbindbar ist, die eine Aufnahme für das metallische Teil und einem dieser benachbarten Elektrode aufweist, wobei zwischen dem metallischen Teil und der Elektrode eine elektrische Spannung angelegt ist und wobei eine silizium- und/oder metallorganische Verbindung in den Raum zwischen der Elektrode und dem Teil zur Bildung der Oxidschicht mittels einer Düse einströmt.

Es werden seit langer Zeit Versuche unternommen, insbesondere auf dem Gebiet der Dentalprothetik, einen Metall-Kunststoff-Verbund zu bilden mit einer hohen Haftfestigkeit des Kunststoffes, beispielsweise auf einem metallischen Trägergerüst. Hierbei besteht die Problematik, daß durch die unterschiedlichen Ausdehnungen zwischen dem Metallteil und dem darauf aufgebrachten Kunststoff sogenannte Randspalte entstehen, die eine verminderte Haftfestigkeit zwischen Metall und Kunststoff bilden oder dazu führen.

Für die Herstellung eines solchen Metall-Kunststoff-Verbundes wurde vorgeschlagen, eine haftvermittelnde Zwischenschicht auf einen Metallträger aufzubringen, der zuvor durch Sandstrahlen in seiner Oberfläche behandelt wurde, auf die dann der Kunststoff chemisch und mechanisch angebunden wird. Als haftvermittelnde Schichten werden für solche Metall-Kunststoff-Verbunde auf das Metallteil silikatische Schichten aufgebracht, die die gewünschten Haftverbesserungen mit sich bringen. Es hat sich jedoch gezeigt, daß die mit solchen silikatische Schichten erzielbaren Haftergebnisse, die sich an der Scherfestigkeit zwischen Metall und Kunststoff messen lassen, von dem Verfahren, mit dem solche Schichten aufgebracht werden, abhängen.

Ein Verfahren bzw. das entsprechende Gerät zur Herstellung eines Metall-Kunststoff-Verbundes ist in dem Deutschen Patent 34 03 894 sowie der Produktinformation der Kulzer GmbH "Das Kulzer Silicoater-Verfahren zur Herstellung eines spaltfreien Kunststoff-Metall-Verbundes in der Zahnheilkunde" (100689/D 260 SK dt.) beschrieben. Nach diesem sogenannten "Silicoater-Verfahren" wird auf eine gesandstrahlte Metalloberfläche eine dünne, glasartige SiOₓ-C-Schicht aufgebracht, und zwar mittels Flammhydrolysebrenner, anschließend ein aktiviertes Haftsilan aufgestrichen und die so gebildete Oberfläche mit einer Opakerschicht versiegelt. Auf diese Schicht kann dann ein Kunststoff aufgetragen werden, wobei sich dieser Metall-Kunststoff-Verbund, insbesondere im Dentalbereich bei der Verblendung von Kronen und Brücken, durch seine Randspaltfreiheit bzw. Scherfestigkeit auszeichnet. Ein anderes Verfahren wird in der aufgeführten Produktinformation als sogenannte "Silicoater MD-Verfahren" beschrieben, bei dem zwischen Kunststoff und Metall eine metalldotierte Schicht (Metalloxidschicht) eingebrannt wird, auf der anschließend eine silikatbildende dende Lösung eingebrannt wird, wobei es zu einer Eindiffusion und einer anschließenden Bindung des Metalloxids an das Silikatgerüst kommt. Diese Silikatschicht bildet dann ein Haftbett für das aufzubringende Haftsilan, das den Untergrund für einen Opaker bzw. einen Kunststoff bildet.

Ein Verfahren der gattungsgemäßen Art ist in Dental-Labor, XXX, Heft 12/82, Seiten 1711 ff. beschrieben, nach dem auf einem Metallsubstrat in einer Reaktionskammer eine Glimmpolymer-Schicht aufgebracht wird. Hierzu werden die Proben in einem evakuierten Behälter, zwischen einer Anode und einer Kathode gebracht und in die Reaktionskammer aus einem Reservoir Triäthoxymethylsilan und Sauerstoff zugeführt. Unter Anlegung eines Gitterstromes von 80 mA und einem Anodenstrom 0,25 A wird ein Plasma erzeugt, in dem die zwischen 13,33 und 40 Pa (0,1 und 0,3 Torr) zugeführten Gase zerlegt werden. Durch lonenbeschuß werden in der Metalloberfläche chemische Defekte erzeugt, über die es zur Bindung mit der sich ausbildenden Glimmpolymerisationsschicht kommt. Nach dieser Oberflächenaktivierung folgt eine Beschichtung mit einem Haftsilan.

Weiterhin ist aus der DD-PS 213 573 ein Plasmareaktor zur Behandlung von in der Zahnmedizin verwendeten Formteilen beschrieben, mit dem auf einem Metallgrundkörper eine Haftvermittlerschicht gebildet wird. Solche vorbehandelten Grundkörper können dann mit Kunststoff verblendet werden. In diesem Plasmareaktor werden die zu beschichtenden Formteile aus Metall als negative Elektrode eingesetzt und ihnen ein gegenüber dem Plasma negatives Elektrodenpotential aufgeprägt. Der Plasmaraum wird über eine Gaszu- und Abführung mit Reaktionsgas gespült.

Die vorstehend angegebenen Verfahren haben sich gut bewährt. Mit diesen Verfahren bzw. den entsprechenden Vorrichtungen können jeweils die Trägerstrukturen in ihrer Gesamtheit mit einer Haftschicht versehen werden. Insbesondere für Reparaturen an einem bereits vorhandenen Metall-Kunststoff-Verbund, der eine Fehlstelle in dem Kunststoff aufweist, ist eine gezielte Beschichtung des Metallunterbaues im Bereich dieser Fehlstelle nicht möglich.

Die vorstehend beschriebenen Verfahren erfordern die Einhaltung spezifischer Verfahrensparameter, um eine gleichmäßige SiOₓ-Haftvermittlerschicht aufzubringen. Insbesondere sind bei dem vorstehend beschriebenen Flammhydrolyseverfahren die Einhaltung von Verfahrensparametern wie Beflammungszeit, Flammenabstand sowie ausreichende Verwirbelung im Bereich des zu beschichtenden Metallteiles wesentlich.

Ausgehend von dem vorstehend beschriebenen Stand der Technik liegt der vorliegenden Erfindung die Aufgabe zugrunde, ein Verfahren und eine Vorrichtung anzugeben, mit der eine SiOₓ-Haftschicht auf einen Metallträger aufgebracht werden kann und mit der es weiterhin möglich ist, den zu beschichtenden Bereich zu selektieren.

Die vorstehende Aufgabe wird bei einem Verfahren der gattungsgemäßen Art dadurch gelöst, daß eine Funkenentladung zwischen der Elektrode und dem Teil erzeugt wird, wobei eine eine stab- oder nadelförmige Spitze aufweisende Elektrode eingesetzt und im Entladungsraum höchstens Atmosphärendruck aufrechterhalten wird, daß zwischen Elektrode und dem Teil eine Potentialdifferenz im Bereich von 1 bis 15 kV erzeugt wird bei einer Feldstärke im Bereich von 0,5 bis 1,5 kV pro Millimeter und daß wenigstens auf die Oberfläche des Teils im Bereich der Entladungsstrecke ein Trägergasstrom gerichtet wird, in dem eine silizium- und/oder metallorganische Verbindung fein verteilt dispergiert ist. Ein solches Verfahren ist in Anspruch 1 beansprucht, mit vorteilhalten Ausführungsformen gemäß den Ansprüchen 2 bis 16.

Hinsichtlich einer Vorrichtung wird die Aufgabe dadurch gelöst, daß eine eine stab- oder nadelförmige Spitze aufweisende Elektrode eingesetzt ist und im Entladungsraum höchstens Atmosphärendruck besteht, daß zwischen Elektrode und dem Teil eine Potentialdifferenz im Bereich von 1 bis 15 kV anliegt bei einer Feldstärke im Bereich von 0,5 bis 1,5 kV pro Millimeter, daß dem Trägergasstrom über eine Dosiereinrichtung die silizium- und/oder metallorganische Verbindung dispergiert wird und daß die Elektrode entweder hülsenförmig ausgebildet ist, wobei die Spitze durch den abgeschrägten Mündungsbereich der Hülse gebildet ist oder daß die Elektrode von einer Hülse umgeben ist, wobei die Hülse zum Führen des Trägergases geeignet ist. Eine solche Vorrichtung ist in Anspruch 17 beansprucht, vorteilhalte Ausführungen der Vorrichtung sind in den Ansprüchen 18 und 19 beansprucht.

Mit dem angegebenen Verfahren bzw. der entsprechenden Vorrichtung ist es möglich, auf dem metallischen Teil sehr gezielt, auch in eng begrenzten Bereichen, eine SiO₂-Schicht auf der Oberfläche abzuscheiden. Durch den Funkenüberschlag zwischen Elektrode und dem metallischen Trägerteil wird dem zu beschichtenden Bereich Energie zugeführt, wodurch die gezielte Beschichtung gefördert wird. Bei der Einleitung einer metallorganischen Verbindung in den Entladungsraum werden auf der Oberfläche die entsprechenden Metalloxide gebildet. Auf der Metalloberfläche scheiden sich die Oxide in Form von Clustern ab, die untereinander agglomerieren und unter dem Einfluß des Funkens (Korona-Funken) Bindung mit dem Metallsubstrat eingehen können. Diese Oxide, insbesondere SiO₂, führen zu ausgezeichneten Verbundeigenschaften zwischen Metall und dem darauf aufzubringenden Kunststoff. Das angegebene Verfahren ist einfach handhabbar, da der erforderliche Funken in definierter Weise über die zu beschichtende Oberfläche geführt werden kann. Weiterhin kann mit dem Verfahren eine sehr homogene Beschichtung durchgeführt werden, da der Funken insbesondere an den Stellen überschlägt, an denen erst geringere Schichtstärken auf der Oberfläche des Metallsubstrates abgeschieden wurden.

Mit einem Trägergasstrom von 100 - 500 l/h wird gewährleistet, daß eine minimal erforderliche Menge der silizium- und/oder metallorganischen Verbindung auf den zu beschichtenden Bereich gebracht wird. Bevorzugt wird der Trägergasstrom auf etwa 200 l/h aufrechterhalten. Falls ein Trägergasstrom gewählt wird, der geringer ist, kann nicht gewährleistet werden, daß die für die Schichtbildungsrate notwendige Gaszufuhr realisiert wird.

Bevorzugt wird, insbesondere mit der vorstehenden Größe des Trägergasstromes, die Menge der silizium- und/oder metallorganischen Verbindungen in dem Trägergasstrom eingestellt, wobei eine Konzentration von < 10 Mol-% verwendet wird und der bevorzugte Bereich bei 0,1 - 0,5 Mol-% liegt.

Üblicherweise reicht es aus, daß im Bereich der Entladungsstrecke eine Luftatmosphäre besteht. Um allerdings eine oxidationsempfindliche Legierung mit dem angegebenen Verfahren zu beschichten, hat es sich als vorteilhaft erwiesen, im Entladungsraum eine Edelgasatmosphäre aufrechtzuerhalten.

Um eine optimale Beschichtungsrate auf der Oberfläche des zu beschichtenden Teiles zu erhalten, sollte die Entladungsstrecke auf eine Stromstärke von < 1 mA/mm eingestellt werden.

Es hat sich als besonders vorteilhaft erwiesen, als siliziumorganische Verbindung eine Verbindung aus der Gruppe der Alkoxisilane einzusetzen; mit einem solchen Alkoxisilan kann das Verfahren insbesondere hinsichtlich des apparativen Aufbaues vereinfacht werden, da sich solche Alkoxisilane durch ihren hohen Dampfdruck auszeichnen und sehr haftfeste und gleichmäßige SiO₂-Schichten bilden, da in solchen Alkoxisilanen der erforderliche Sauerstoff bereits enthalten ist.

Um eine gute Verbindung zu dem auf der Haftschicht aufzubringenden Kunststoff zu erreichen, sollte die zu bildende Oxidschicht zumindest zu 50 % aus einer siliziumorganischen Verbindung gebildet werden. Die dieser siliziumorganischen Verbindung zugesetzten weiteren metallorganischen Verbindungen dienen zur Haftoxidation an dem Metallträger, so daß durch diese Zwischenschicht sowohl eine ausreichende Verbindung zu dem Metallträger einerseits und zu dem Kunststoff andererseits hergestellt wird.

Bei Einsatz von silizium- bzw. metallorganischen Verbindungen, die Sauerstoff enthalten, kann zur Erzeugung der gewünschten metalloxidischen Haftschicht auf die zusätzliche Einspeisung eines sauerstoffhaltigen Gasgemisches verzichtet werden. In solchen Fällen bietet der Einsatz von Stickstoff und/oder Edelgas die Möglichkeit, die Schichtbildungsbedingungen sehr reproduzierbar festzulegen, wobei ggf. durch einen definierten Zusatz an Sauerstoff die notwendige Stöchiometrie von Silizium zu Sauerstoff in der verwendeten siliziumund/oder metallorganischen Verbindung optimiert werden kann.

Dem Gasstrom sollte eine gewisse Konzentration an Wasser, bevorzugt < 50 mol-%, zugemischt werden, und zwar in seiner dampfförmigen Phase, um dadurch die Geschwindigkeit der SiO₂-Bildung zu erhöhen. Durch diesen Wasserdampf wird auf dem Metallgerüst eine vollständige Hydrolyse der metallorganischen Verbindung erreicht. Das bevorzugte Mol-Verhältnis der metallorganischen Verbindung zu dem Wasser bzw. dem Wasserdampf liegt im Bereich von 1 : 4.

Die Haftung von aus siliziumorganischen Verbindungen gebildeten SiO₂-Schichten kann dadurch verbessert werden, daß für ausgewählte Metalle, wie beispielsweise titanhaltige Legierungen oder auch Aluminium, Titan-, Zirkonium-, Aluminium- und/oder Zinn-Verbindungen in der Anfangsphase der Schichtbildung eingesetzt oder der siliziumorganischen Verbindung zudosiert werden. In diesem Zusammenhang haben sich titanhaltige Verbindungen als besonders wirkungsvoll erwiesen.

Bei Verwendung einer siliziumorganische Verbindung hat sich besonders vorteilhaft ein Tetramethoxysilan bewährt, da dieses Silan einen ausreichend hohen Dampfdruck besitzt, wodurch der notwendige Luftstrom klein gehalten wird. Es hat sich gezeigt, daß bei zu hoher Zufuhr von Luft der Wirkungsgrad niedrig wird, d. h. die Zeitdauer, mit der das Metallgerüst behandelt werden muß, wird erhöht.

Als silizium- oder metallorganische Verbindung, die schwer flüchtig ist, sollte der Trägergasstrom, mit dem diese Verbindung in den Entladungsraum eingeführt wird, vor Eintritt in den Entladungsraum temperiert werden; hierdurch wird die Rate des Schichtaufbaus heraufgesetzt, d. h. die Behandlungszeit des Metallgerüstes kann, bezogen auf die zu beschichtende Flächeneinheit, reduziert werden.

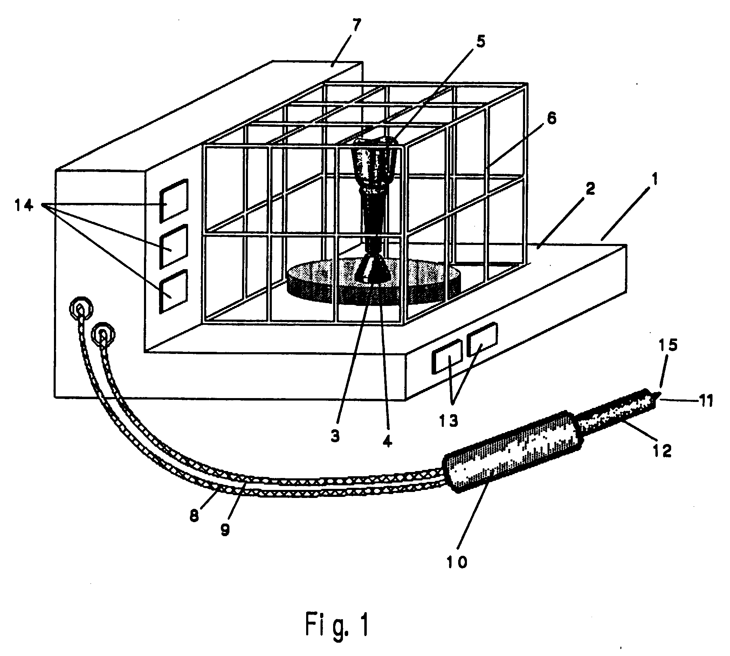

Nachfolgend werden zwei Ausführungsbeispiele angegeben. Für diese Ausführungsbeispiele wurde eine Vorrichtung verwendet, wie sie in der Figur 1 dargestellt ist. Die Vorrichtung wurde mit folgenden Parametern betrieben:
Angelegte Spannung: 8 kV
Luft/Silanzuführung über eine Lochdüse mit einem Innendurchmesser von 1 mm
Luftführung von 200 l/h
verwendetes Silan: TMOS, Durchsatz 0,3 g/h

### Ausführungsbeispiel 1

Gegossene Metallsubstrate mit einer Kantenlänge von 2 cm x 1 cm x 0,2 cm wurden mit feinkörnigem Aluminiumoxid (mittlere Körnung 250 µm) mit einem Druck von 4 bar gestrahlt.

Die so vorbereiteten Substrate wurden anschließend durch Funkenentladung in einem Abstand von 5 mm behandelt, wobei ein Luft/Silangemisch über eine Lochdüse mit einem Innendurchmesser von 1 mm dem Entladungsbereich auf dem Substrat zugeführt wurde. Die Behandlungszeit für eine Fläche von 1 x 1 cm betrug 45 Sekunden. Die zwischen Elektrode und Substrat angelegte Spannung betrug 8 KV. Auf diese Oberfläche wurde dann ein Haftsilan (Siliseal der Firma Heraeus Kulzer GmbH, Wehrheim), anschließend eine Opakerschicht (bestehend aus Opakerpulver C 30 und Opakerflüssigkeit, in einem Mischungsverhältnis von 1:1 Gew.%, der Heraeus Kulzer GmbH) aufgetragen. Auf den so vorbereiteten Aufbau wurde ein Kunststoffzylinder mit einem Durchmesser von 5 mm und einer Höhe von 3 mm unter Zuhilfenahme eines Metallrings als Präparationshilfsmittel aus einem Dentacolor^{R} - Kunststoff (Dentacolor^{R} = eingetragenes Warenzeichen der Heraeus Kulzer GmbH) aufgebracht. Bei Dentacolor handelt es sich um einen polymerisierbaren Einkomponenten-Kunststoff. Opaker und Kunststoff wurden nach Herstellerangaben in einem Lichtpolymerisationsgerät ausgehärtet.

Diese Proben wurden dann hinsichtlich der Scherfestigkeit des Metall-Kunststoff-Verbundes nach 30 Minuten Kochtest geprüft mit den nachfolgenden Ergebnissen, wobei der Verfahrensschritt der Behandlung mittels Funkenentladung bei den Leerwerten nicht durchgeführt wurde.

| Dentallegierung (Metallsubstrat) | Leerwert Scherfestigkeit [MPa] | mit Silikatisierung durch Funkenentladung Scherfestigkeit [MPa] |
|---|---|---|
| Hera GG | 16 ± 2 | 26 ± 2 |
| Maingold SG | 15 ± 2 | 27 ± 3 |
| Heraenium CE | 9 ± 2 | 25 ± 3 |

### Ausführungsbeispiel 2

Nach diesem Ausführungsbeispiel wurden die Metallsubstrate mit dem Ausführungsbeispiel 1 entsprechenden Verfahrensparametern behandelt und ein entsprechender Metall-Kunststoff-Verbund hergestellt. Gegenüber Ausführungsbeispiel 1 wurde anstelle einer Luft-Silanzuführung eine Argon/Silanzuführung gewählt. Die verschiedenen Metallsubstrate wurden ebenfalls einem 30 Minuten Kochtest unterzogen mit folgenden Ergebnissen:

| Dentallegierung (Metallsubstrat) | Leerwert Scherfestigkeit [MPa] | mit Silanisierung durch Corona-Funken Scherfestigkeit [MPa] |
|---|---|---|
| Hera GG | 16 ± 2 | 24 ± 3 |
| Maingold SG | 15 ± 2 | 24 ± 2 |
| Palliag M | 13 ± 2 | 22,5 ± 2 |
| Degulor M | 14 ± 2 | 19 ± 2 |
| Heraenium CE | 12 ± 2 | 23 ± 2 |

Die in den Ausführungsbeispielen 1 und 2 eingesetzten Dentallegierungen können wie folgt spezifiziert werden:
- Hera GG: - goldreduzierte Goldgußlegierung gemäß Spezifikation DIN 13906 mit 55,6% Au, einem hohen Anteil an Silber (22,9% Ag), 0,6% Pd, 3,8% Pd und 13 % Cu
- Maingold^{R}: - hochgoldhaltige Goldgußlegierung gemäß Spezifikation DIN 13906 mit 71,0% Au, 12,3% Ag, 2,0% Pt, 2,0% Pd und 12,2% Cu Maingold^{R} = registriertes Warenzeichen der Heraeus Kulzer GmbH
- Heraenium^{R}: - CoCrMo-Modellgußlegierung mit 63,5% Co, 27,8% Cr, 6,5% Mo und geringen Anteilen an Si, C und N Heraenium^{R} = registriertes Warenzeichen der W. C. Heraeus GmbH
- Palliag^{R}M: - Silber-Palladium-Legierung Palliag^{R} = registriertes Warenzeichen der Degussa AG
- Degulor^{R}M: - hochgoldhaltige Goldgußlegierung Degulor^{R} = registriertes Warenzeichen der Degussa AG

Die vorstehenden Ausführungsbeispiele zeigen, daß die mit dem erfindungsgemäßen Verfahren durchgeführte Oberflächenbehandlung des Metallsubstrats im Hinblick auf den Leerwert, d.h. ohne eine Behandlung mittels Funkenentladung, auf bis zu 100 % höhere Scherfestigkeitswerte gebracht werden können, wobei dies insbesondere auch für hoch goldhaltige Gußlegierungen, Silber-Palladium-Legierungen, als auch für Kobalt-Chrom-Molybdän-Legierungen gilt.

Nachfolgend wird detailliert eine Vorrichtung zur Herstellung eines Metall-Kunststoffverbundes beschrieben. In der Zeichnung zeigt
- Fig. 1: eine perspektivische Ansicht der Vorrichtung,
- Fig. 2: ein Griffstück, wie es in Verbindung mit der Vorrichtung nach Fig. 1 verwendet wird, wobei die Elektrode in einer Schnittdarstellung gezeigt ist,
- Fig. 3: ein Griffstück entsprechend der Fig. 2 mit einer geänderten Elektrode, und
- Fig. 4: eine Schaltungsanordnung, wie sie in der Vorrichtung nach der Fig. 1 eingesetzt ist.

Die Vorrichtung weist ein Gehäuse 1 mit einer Konsole oder Basisplatte 2 auf. Auf der Konsole 2 ist eine Halterung 3 mit einem Träger 4 befestigt, wobei der Träger 4 ein metallisches Teil 5, beispielsweise ein Trägergerüst für eine aufzubauende Dentalprothese, erträgt. Die Halterung 3, der Träger 4 und das metallische Teil 5 sind von einem von einem Faraday-Käfig 6 umgeben, wobei dieser Käfig durch grobe Maschen gebildet wird, beispielsweise durch Metallstäbe, so daß das metallische Teil 5 durch die Maschen des Käfigs 6 hindurch gut zugängig ist. Seitlich eines hinteren Wandteiles 7 des Gehäuses 1, an dem der Käfig 6 anliegt, sind zwei Zuführleitungen 8, 9 herausgeführt, an deren Ende ein Griffstück 10 angeordnet ist, von dessen Ende eine Elektrode 11 vorsteht, die von einer Hülse 12 umgeben ist. Die eine Zuführleitung 8 dient als Stromzuführung zu der Elektrode 11, während die andere Zuführleitung 9 eine silizium- und/oder metallorganische Verbindung durch das Griffstück 10 hindurch der Hülse 12 zuführt. Weiterhin sind an dem Gehäuse 1 mehrere Bedienungselemente 13, beispielsweise zum Ein-/ oder Ausschalten der Stromversorgung der Elektrode, angeordnet, weitere Bedienungs- und Anzeigeelemente 14 sind seitlich an dem Wandteil 7 des Gehäuses 1 eingesetzt, um die Parameter, mit denen die Vorrichtung betrieben wird, einzustellen, zu steuern und/oder zu überwachen.

Um auf den metallischen Teil 5 die silizium- und/oder metallorganische Verbindung, die über die Zuführleitung 9 der Hülse 12 zugeführt wird, aufzubringen, wird das Gerät an den Bedienungselementen 13 eingeschaltet und damit eine Potentialdifferenz zwischen der Elektrode 11 und dem metallischen Teil 5 erzeugt. Die Elektrode 11 wird dann über das Griffstück 10 geführt, der Oberfläche des metallischen Teiles 5 angenähert, wobei die nadelförmige Spitze 15 der Elektrode 11 solchen Bereichen genähert wird, die mit der Verbindung beschichtet werden soll. Je nach Höhe der eingestellten Feldstärke, die im Bereich von 0,5 bis 1,5 KV pro Millimeter beträgt, findet eine elektrische Entladung zwischen der Elektrode 11 und dem metallischen Teil 5 durch Funkenentladung beziehungsweise Korona-Entladung statt. Gleichzeitig mit der Entladung wird über die Zuführleitung 9 die metallorganische Verbindung dem Entladungsraum zwischen der Elektrodenspitze 15 und dem metallischen Teil 5 zugeführt, und zwar in einem Trägergasstrom über eine nicht näher dargestellte Dosiereinrichtung dispergiert zugeführt, die sich dann im Bereich der Entladungszone auf dem metallischen Teil 5, unterstützt durch Energiezufuhr auf das metallische Teil in diesem Bereich, niederschlägt. Mit dieser Anordnung kann das metallische Teil sehr gezielt auch in engen begrenzten Bereichen seine Oberfläche gezielt beschichtet werden.

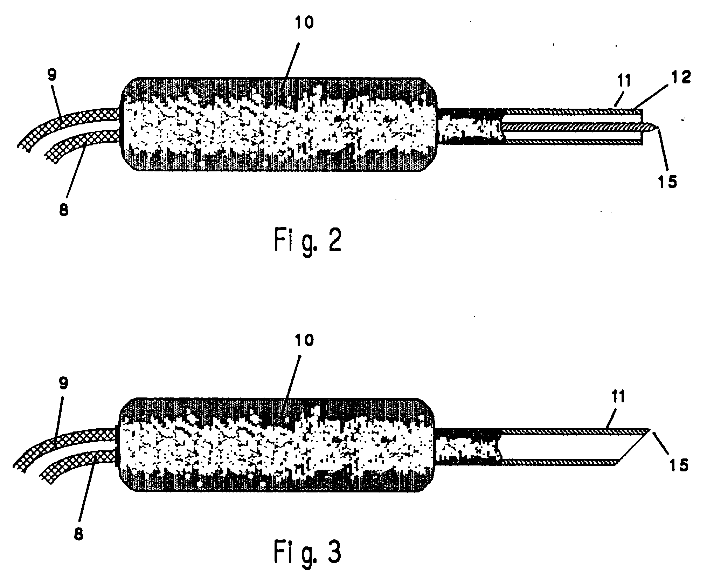

In den Figuren 2 und 3 sind verschiedene Elektroden-/Düsen-Anordnungen gezeigt, wobei die Anordnung nach der Figur 2 eine Elektrode 11 aufweist, die koaxial von der Hülse 12 umgeben ist. Zwischen der Elektrode 11 und der Hülse 12 wird ein Ringraum 16 gebildet, dem über die Zuführleitung 9 der Trägergasstrom mit der darin dispergierten silizium- und/oder metallorganischen Verbindung zugeführt wird. Darüberhinaus kann die Elektrode 11 in ihrer über das Ende der Hülse 12 vorstehenden Länge eingestellt werden; gleichzeitig kann mit einer solchen Einstellung durch entsprechende Ausbildung des Endes der Hülse 12 beziehungsweise des Endes der Elektrode 11 dazu dienen, den Trägergasstrom mit der Verbindung im Bereich der Elektrodenspitze beziehungsweise des Entladungsraumes einzustellen. Diese Einstellung kann einerseits im Hinblick auf den Austrittskegel erfolgen, andererseits aber auch im Hinblick auf die Stärke des Stromes.

Die Figur 3 zeigt eine vereinfachte Ausführungsform der Elektrode, wobei die Hülse 12, wie sie in Figur 2 gezeigt ist, gleichzeitig die Elektrode bildet, das heißt sie ist aus einem leitenden Werkstoff gebildet, der zu Isolationszwecken von einer zusätzlichen äußeren Isolierung umgeben sein kann, während in der Ausführung nach der Figur 2 die Hülse 12 komplett aus isolierendem Werkstoff gefertigt sein kann. In der Ausführung nach Figur 3 ist die hülsenförmige Elektrode in ihrem Mündungsbereich abgeschrägt, so daß eine Spitze entsteht, um zu gewährleisten, daß ein gezielter Überschlag beziehungsweise gezielte Korona-Bildung zwischen der Spitze und dem metallischen Teil 5 gewährleistet ist.

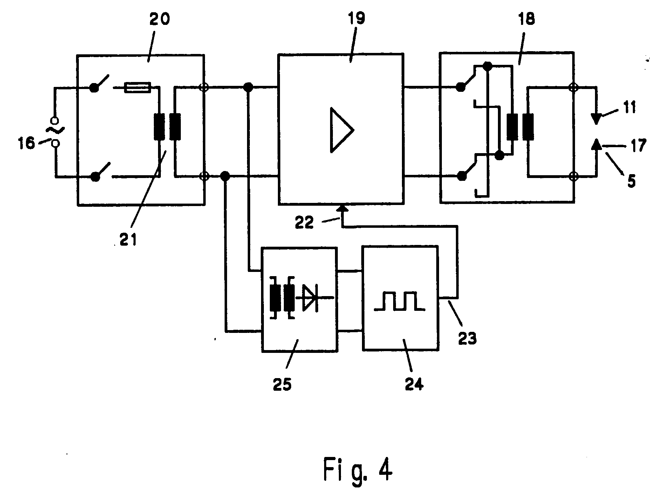

In Figur 4 ist die elektrische Schaltungsanordnung gezeigt, wobei mit dem Bezugszeichen 16 der Netzanschluß bezeichnet ist, während die Pfeile 17 die Elektrode 11 beziehungsweise den das metallische Teil 12 andeuten. Die Elektroden 11 werden von einer Zündspule 18 gespeist, der ein steuerbarer Schalter 19 oder Impulsverstärker und ein Netzteil mit einem Trenntransformator 20 vorgeschaltet ist. Der Trenntransformator 21, der in Figur 4 als Teil des Netzteiles 20 dargestellt ist, trennt die Netzversorgung gegenüber dem Hochspannungsteil ab. Die Zündspule 18 erzeugt die erforderlichen Spannungen von 1 bis 15 KV, die wahlweise über den steuerbaren Schalter 19 eingestellt werden. Der steuerbare Schalter 19 weist einen Steuereingang 22 auf, der mit dem Ausgang 23 eines Impulsgebers 24 verbunden ist. Der Impulsgeber 24 besitzt eine eigene Stromversorgung 25, deren Stromversorgung von der Sekundärspule des Trenntransformators 21 abgegriffen wird. Über den Impulsgeber 24 werden Steuerimpulse zur Erzeugung einer Impulsfolge abgeleitet, um die Zündspule 18 mit der gewünschten Frequenz anzusteuern.

## Patentansprüche

1. Verfahren zur Herstellung eines Metall-Kunststoff-Verbundes, insbesondere für die Dentalprothetik, wobei auf einem metallischen Teil eine haftvermittelnde Oxidschicht aufgebaut wird, die dann mit einem Kunststoff, insbesondere Dentalkunststoff, über eine Zwischenschicht aus einem Haftsilan verbunden wird, wobei zwischen dem metallischen Teil und einer ihr benachbarten Elektrode eine elektrische Spannung erzeugt und aufrechterhalten wird und wobei eine siliziumorganische Verbindung in den Raum zwischen der Elektrode und dem Teil zur Bildung der Oxidschicht eingeleitet wird, dadurch gekennzeichnet, daß eine Funkenentladung zwischen der Elektrode und dem Teil erzeugt wird, wobei eine eine stab- oder nadelförmige Spitze aufweisende Elektrode eingesetzt und im Entladungsraum höchstens Atmosphärendruck aufrechterhalten wird, daß zwischen Elektrode und dem Teil eine Potentialdifferenz im Bereich von 1 bis 15 kV erzeugt wird bei einer Feldstärke im Bereich von 0,5 bis 1,5 kV pro Millimeter und daß wenigstens auf die Oberfläche des Teils im Bereich der Entladungsstrecke ein Trägergasstrom gerichtet wird, in dem eine silizium- und/oder metallorganische Verbindung gasförmig und/oder fein verteilt dispergiert vorliegt.

2. Verfahren nach Anspruch 1, dadurch gekennzeichnet, daß ein Trägergasstrom von 100 - 500 Litern/Stunde aufrechterhalten wird.

3. Verfahren nach Anspruch 3, dadurch gekennzeichnet, daß der Trägergasstrom mit etwa 200 Litern/Stunde aufrechterhalten wird.

4. Verfahren nach einem der Ansprüche 1 bis 3, dadurch gekennzeichnet, daß die Konzentration der silizium- und/oder metallorganischen Verbindung in dem Trägergasstrom auf kleiner 10 Mol-% eingestellt wird.

5. Verfahren nach Anspruch 4, dadurch gekennzeichnet, daß die Konzentration der silizium- und/oder metallorganischen Verbindung in dem Trägergasstrom auf 0,1 - 0,5 Mol-% eingestellt wird.

6. Verfahren nach einem der Ansprüche 1 bis 4, dadurch gekennzeichnet, daß im Entladungsraum eine Edelgasatmosphäre erzeugt wird.

7. Verfahren nach einem der Ansprüche 1 bis 6, dadurch gekennzeichnet, daß die Ionenstromdichte an der Oberfläche des Teils im Bereich der Entladungsstrecke kleiner 1 bis 10 mA/mm eingestellt wird.

8. Verfahren nach einem der Ansprüche 1 bis 7, dadurch gekennzeichnet, daß als siliziumorganische Verbindung eine Verbindung aus der Gruppe der Alkoxysilane verwendet wird.

9. Verfahren nach einem der Ansprüche 1 bis 8, dadurch gekennzeichnet, daß die Verbindung zur Bildung der Oxidschicht zu mindestens 50 % eine siliziumorganische Verbindung ist.

10. Verfahren nach einem der Ansprüche 1 bis 9, dadurch gekennzeichnet, daß als Trägergas ein inertes Gas oder ein Gasgemisch aus Sauerstoff, Stickstoff und/oder Edelgas eingesetzt wird.

11. Verfahren nach einem der Ansprüche 1 bis 10, dadurch gekennzeichnet, daß dem Gasstrom Wasser in einer Konzentration kleiner 50 Mol-% zugesetzt wird, das in den Bereich der Entladungsstrecke in seiner dampfförmigen Phase eingebracht wird.

12. Verfahren nach Anspruch 11, dadurch gekennzeichnet, daß das Mol-Verhältnis der metallorganischen Verbindung zu Wasser zwischen 1:0,5 bis 1:4 eingestellt wird.

13. Verfahren nach einem der Ansprüche 1 bis 12, dadurch gekennzeichnet, daß als metallorganische Verbindung eine Titan-, Zirkonium-, Aluminium- und/oder Zinn-Verbindung eingesetzt wird.

14. Verfahren nach Anspruch 13, dadurch gekennzeichnet, daß als metallorganische Verbindung im wesentlichen eine Titan-Verbindung eingesetzt wird.

15. Verfahren nach einem der Ansprüche 1 bis 14, dadurch gekennzeichnet, daß als siliziumorganische Verbindung Tetramethoxysilan eingesetzt wird.

16. Verfahren nach einem der Ansprüche 1 bis 15, dadurch gekennzeichnet, daß das Trägergas vor Eintritt in den Entladungsraum temperiert wird.

17. Vorrichtung zur Herstellung eines Metall-Kunststoff-Verbundes, insbesondere für die Dentalprothetik nach einem der Ansprüche 1 bis 16, wobei ihr Betrieb der Vorrichtung auf einem metallischen Teil eine haftvermittelnde Oxidschicht aufgebaut wird, die dann mit einem Kunststoff, insbesondere Dentalkunststoff verbindbar ist, die eine Aufnahme für das metallische Teil und eine dieser benachbarten Elektrode aufweist, wobei ihr Betrieb der Vorrichtung zwischen dem metallischen Teil und der Elektrode eine elektrische Spannung angelegt ist und eine silizium- und/oder metallorganische Verbindung in den Raum zwischen der Elektrode und dem Teil zur Bildung der Oxidschicht mittels einer Düse einströmt, dadurch gekennzeichnet, daß eine eine stab- oder nadelförmige Spitze (15) aufweisende Elektrode (11) eingesetzt ist und ihr Betrieb der Vorrichtung im Entladungsraum höchstens Atmosphärendruck besteht, daß zwischen Elektrode (11) und dem Teil (5) eine Potentialdifferenz im Bereich von 1 bis 15 kV anliegt bei einer Feldstärke im Bereich von 0,5 bis 1,5 kV pro Millimeter, daß dem Trägergasstrom über eine Dosiereinrichtung die silizium- und/oder metallorganische Verbindung dispergiert wird und daß die Elektrode (11) entweder hülsenförmig ausgebildet ist, wobei die Spitze (15) durch den abgeschrägten Mündungsbereich der Hülse (12) gebildet ist oder daß die Elektrode (11) von einer Hülse (12) umgeben ist, wobei die Hülse (12) zum Führen des Trägergases geeignet ist.

18. Vorrichtung nach Anspruch 17, dadurch gekennzeichnet, daß die Elektrode (11) ein stiftförmiger Hohlstift ist, durch den der Trägergasstrom geleitet wird.

19. Vorrichtung nach Anspruch 17 oder 18, dadurch gekennzeichnet, daß die Spitze (15) der Elektrode (11) einen Durchmesser von etwa 0,3 mm bis 1 mm aufweist.

## Claims

1. A method for the production of a metal/plastic composite, in particular for dental prosthetics, in which an oxide layer acting as an adhesion agent, is built up on a metallic part, which oxide later is then connected with a plastic, in particular dental plastic, via an intermediate layer of a silane adhesive, in which between the metallic part and an electrode adjacent thereto an electric voltage is generated and maintained and in which an organosilane compound is introduced into the space between the electrode and the part for the formation of the oxide layer, characterised in that a spark discharge is produced between the electrode and the part, in which an electrode is used having a rod- or needle-shaped point and a pressure of at most atmospheric is maintained in the discharge chamber, that between the electrode and the part a potential difference in the range of 1 to 15 kV is produced with a field intensity in the range of 0.5 to 1.5 kV per millimetre and that a stream of carrier gas is directed at least onto the surface of the part in the region of the discharge section, in which stream of carrier gas an organosilicon and/or organometallic compound is present, in gaseous form and/or dispersed in a finely distributed manner.

2. A method according to claim 1, characterised in that a stream of carrier gas of 100-500 litres/hour is maintained.

3. A method according to claim 3, characterised in that the stream of carrier gas is maintained at approximately 200 litres/hour.

4. A method according to one of claims 1 to 3, characterised in that the concentration of the organosilicon and/or organometallic compound in the stream of carrier gas is set at less than 10 mole %.

5. A method according to claim 4, characterised in that the concentration of the organosilicon and/or organometallic compound in the stream of carrier gas is set at 0.1 - 0.5 mole %.

6. A method according to one of claims 1 to 4, characterised in that a noble gas atmosphere is produced in the discharge chamber.

7. A method according to one of claims 1 to 6, characterised in that the ion current density on the surface of the part in the region of the discharge section is set at less than 1 to 10 mA/mm.

8. A method according to one of claims 1 to 7, characterised in that a compound of the group of alkoxysilanes is used as the organosilicon.

9. A method according to one of claims 1 to 8, characterised in that the compound for the formation of the oxide layer is at least 50% organosilicon compound.

10. A method according to one of claims 1 to 9, characterised in that an inert gas or a gas mixture of oxygen, nitrogen and/or noble gas is used as the carrier gas.

11. A method according to one of claims 1 to 10, characterised in that water at a concentration of less than 50 mole % is added to the gas stream, which water is introduced into the region of the discharge section in its vapour stage.

12. A method according to claim 11, characterised in that the molar ratio of the organometallic compound to water is set between 1:0.5 to 1:4.

13. A method according to one of claims 1 to 12, characterised in that a titanium, zirconium, aluminium and/or tin compound is used as the organometallic compound.

14. A method according to claim 13, characterised in that as the organometallic compound is substantially a titanium compound is used.

15. A method according to one of claims 1 to 14, characterised in that tetramethoxysilane is used as the organosilicon compound.

16. A method according to one of claims 1 to 15, characterised in that the carrier gas is brought up to temperature before entry into the discharge chamber.

17. A device for the production of a metal/plastic composite, in particular for dental prosthetics, according to one of claims 1 to 16, in which the operation of the device, an oxide layer, acting as adhesion agent, is built up on a metallic part, which oxide layer is then bondable to a plastics, in particular dental plastics, which has a mounting for the metallic part and an electrode adjacent thereto, in which in operation of the device an electric voltage is applied between the metallic part and the electrode and an organosilicon and/or organometallic compound flows by means of a nozzle into the space between the electrode and the part for the formation of the oxide layer, characterised in that an electrode (11) having a rod- or needle-shaped point (15) is used and in the operation of the device at a pressure of at most atmospheric prevails in the discharge chamber, that between electrode (11) and the part (5) there is a potential difference in the range of 1 to 5 kV with a field intensity in the range of 0.5 to 1.5 kV per millimetre, that the organosilicon and/or organometallic compound is dispersed to the stream of carrier gas *via* a dosing device and that the electrode (11) is either constructed in a sleeve shape, in which the point (15) is formed by the chamfered opening region of the sleeve (12) or that the electrode (11) is surrounded by a sleeve (12), the sleeve (12) being suitable for guiding the carrier gas.

18. A device according to claim 17, characterised in that the electrode (11) is a pin-shaped hollow pin, through which the stream of carrier gas is directed.

19. A device according to claim 17 or 18, characterised in that the point (15) of the electrode (11) has a diameter of approximately 0.3 mm to 1 mm.

## Revendications

1. Procédé pour la préparation d'un composite métal-matière plastique, en particulier pour les prothèses dentaires, une couche d'oxyde adhérente étant constituée sur une partie métallique, laquelle est ensuite liée à une matière plastique, en particulier une matière plastique dentaire, par l'intermédiaire d'une couche intermédiaire constituée d'un silane d'adhérence, une tension électrique étant produite et maintenue entre la partie métallique et une électrode voisine à celle-ci et un composé organique du silicium étant introduit dans l'espace entre l'électrode et la partie pour la formation de la couche d'oxyde, caractérisé en ce qu'on produit une décharge à étincelles entre l'électrode et la partie, une électrode présentant une pointe en forme de barre ou d'aiguille étant utilisée et maintenue dans la zone de décharge au plus à la pression atmosphérique, en ce qu'on produit entre l'électrode et la partie une différence de potentiel dans le domaine de 1 à 15 kV pour une intensité de champ dans le domaine de 0,5 à 1,5 kV/mm et en ce qu'on dirige au moins sur la surface de la partie dans le domaine de l'espace de décharge un courant de gaz porteur, dans lequel se trouve dispersé un composé organique du silicium et/ou d'un métal sous forme gazeuse et/ou finement divisée.

2. Procédé selon la revendication 1, caractérisé en ce qu'on maintient un courant de gaz porteur de 100 - 500 l/h.

3. Procédé selon la revendication 2, caractérisé en ce qu'on maintient le courant de gaz porteur à environ 200 l/h.

4. Procédé selon l'une quelconque des revendications 1 à 3, caractérisé en ce qu'on ajuste la concentration du composé organique du silicium et/ou d'un métal dans le courant de gaz porteur à moins de 10 % en mole.

5. Procédé selon la revendication 4, caractérisé en ce qu'on ajuste la concentration du composé organique du silicium et/ou d'un métal dans le courant de gaz porteur à 0,1 - 0,5 % en mole.

6. Procédé selon l'une quelconque des revendications 1 à 4, caractérisé en ce qu'on produit dans la zone de décharge une atmosphère de gaz rare.

7. Procédé selon l'une quelconque des revendications 1 à 6, caractérisé en ce qu'on ajuste la densité du courant ionique sur la surface de la partie dans le domaine de l'espace de décharge à moins de 1 à 10 mA/mm.

8. Procédé selon l'une quelconque des revendications 1 à 7, caractérisé en ce qu'on utilise en tant que composé organique du silicium un composé du groupe des alcoxysilanes.

9. Procédé selon l'une quelconque des revendications 1 à 8, caractérisé en ce que le composé pour la formation de la couche d'oxyde est jusqu'à au moins 50 % un composé organique du silicium.

10. Procédé selon l'une quelconque des revendications 1 à 9, caractérisé en ce qu'on utilise en tant que gaz porteur un gaz inerte ou un mélange de gaz constitué d'oxygène, d'azote et/ou de gaz rares.

11. Procédé selon l'une quelconque des revendications 1 à 10, caractérisé en ce qu'on ajoute au courant de gaz de l'eau dans une concentration inférieure à 50 % en mole, qui est apportée dans le domaine de l'espace de décharge dans sa phase vapeur.

12. Procédé selon la revendication 11, caractérisé en ce qu'on ajuste le rapport molaire du composé organométallique à l'eau entre 1:0,5 et 1:4.

13. Procédé selon l'une quelconque des revendications 1 à 12, caractérisé en ce qu'on utilise en tant que composé organométallique un composé du titane, du zirconium, de l'aluminium et/ou de l'étain.

14. Procédé selon la revendication 13, caractérisé en ce qu'on utilise en tant que composé organométallique essentiellement un composé du titane.

15. Procédé selon l'une quelconque des revendications 1 à 14, caractérisé en ce qu'on utilise en tant que composé organique du silicium du tétraméthoxysilane.

16. Procédé selon l'une quelconque des revendications 1 à 15, caractérisé en ce qu'on tempère le gaz porteur avant l'entrée dans la zone de décharge.

17. Dispositif pour la préparation d'un composite métal-matière plastique, en particulier pour les prothèses dentaires, selon l'une quelconque des revendications 1 à 16, une couche d'oxyde adhérente étant constituée lors du fonctionnement du dispositif sur une partie métallique, laquelle peut ensuite être liée à une matière plastique, en particulier une matière plastique dentaire, qui présente une réception pour la partie métallique et une électrode voisine à celle-ci, une tension électrique étant appliquée lors du fonctionnement du dispositif entre la partie métallique et l'électrode et un composé organique du silicium et/ou d'un métal étant introduit au moyen d'une buse dans l'espace entre l'électrode et la partie pour la formation de la couche d'oxyde, caractérisé en ce qu'on utilise une électrode (11) présentant une pointe (15) en forme de barre ou d'aiguille et lors du fonctionnement du dispositif la pression dans la zone de décharge est au plus la pression atmosphérique, en ce qu'on applique entre l'électrode (11) et la partie (5) une différence de potentiel dans le domaine de 1 à 15 kV pour une intensité de champ dans le domaine de 0,5 à 1,5 kV/mm, en ce qu'on disperse dans le courant de gaz porteur par l'intermédiaire d'un dispositif de dosage le composé organique du silicium et/ou d'un métal et en ce que l'électrode (11) a soit la forme d'un manchon, la pointe (15) étant formée par le domaine d'embouchure en biseau du manchon (12), soit en ce que l'électrode (11) est entourée d'un manchon (12), le manchon (12) étant approprié pour guider le gaz porteur.

18. Dispositif selon la revendication 17, caractérisé en ce que l'électrode (11) est une pointe creuse en forme de crayon, à travers laquelle on introduit le courant de gaz porteur.

19. Dispositif selon la revendication 17 ou 18, caractérisé en ce que la pointe (15) de l'électrode (11) présente un diamètre d'environ 0,3 mm à 1 mm.
